# EUROPEAN PATENT SPECIFICATION

(11) **EP 1 181 548 B1**
(45) Date of publication and mention of the grant of the patent: **21.03.2007**
(21) Application number: 00921690.4
(22) Date of filing: 05.04.2000
(51) Int. Cl.: G01N 31/00, G01N 33/00, C30B 7/00

(54) **METHOD FOR SCREENING CRYSTALLIZATION CONDITIONS IN SOLUTION CRYSTAL GROWTH**
VORRICHTUNG ZUM SCREENING VON KRISTALLISIERUNGSBEDINGUNGEN IN LÖSUNGEN ZUR KRISTALLZÜCHTUNG
PROCEDE DE CRIBLAGE DES CONDITIONS DE CRISTALLISATION DANS DES SOLUTIONS DE TIRAGE DE CRISTAL

(30) Priority: 06.04.1999 US 128018 P
(43) Date of publication of application: 27.02.2002
(60) Divisional application: 06075121.1
(73) Proprietor: The University of Alabama at Birmingham Research Foundation, Birmingham, AL 35294-0111 (US)
(72) Inventor: DELUCAS, Lawrence, J., Birmingham, AL 35243 (US); BRAY, Terry, L., Birmingham, AL 35216 (US)
(74) Representative: Bizley, Richard Edward
(86) International application number: PCT/US2000/008977
(87) International publication number: WO 2000/060345

(56) References cited:
- DE-A- 19 631 395
- US-A- 4 833 233
- US-A- 5 096 676
- US-A- 5 419 278
- US-A- 5 641 681
- US-A- 6 057 159

## Description

### Field of the Invention

The present invention relates to the crystallization of proteins in or from protein solutions. The present invention particularly relates to a method of screening a large number of protein crystal growth conditions which may be conducive to protein crystallization. Even more particularly, the present invention relates to a method which identifies one or more optimum protein crystal growth conditions, while at the same time using substantially less protein solution.

### Background of the Invention

The crystallization of proteins for structure-function studies and structure based drug design has become an increasingly important part of biotechnology research. When crystal growth is attempted for a new protein, the appropriate chemical conditions (i.e. protein concentration in solution, precipitate type and concentration, pH, and growth temperature) are unknown and have typically been determined by trial and error experimentation.

Typically 1000 or more different sets of crystal growth conditions are screened to determine conditions conducive to crystallization. The screening involves repetitive procedures that are extremely laborious and tedious. With present laboratory protein crystal growth equipment, each crystallization chamber requires about one micro-liter of protein solution. The protein solutions typically have concentrations in the range of 10 to 25 micrograms per microliter to facilitate crystal growth. Therefore, to screen 1000 samples typically requires between 10 and 25 milligrams of protein. This is a considerable and costly amount, especially for proteins that are difficult to isolate or generally express. A large percentage (about 50%) of the proteins cannot easily be expressed in milligram quantities.

Thus, it would be desirable to provide methods for screening protein crystal growth conditions that require picogram to microgram amounts of protein for each screening condition. Preferably such methods would require only picogram to nanogram amounts of protein in picoliter to nanoliter volumes in each screening condition sample.

It would be further desirable to provide high throughput screening methods for screening protein crystal growth conditions in a large number of samples on a sub-microgram scale. These methods would use a microarray as a platform for protein crystal growth. The methods would also utilize automatic dispensing of solutions and scoring of crystal growth.

### Summary of the Invention

The present invention is a method of screening protein crystal growth conditions employing a minimal amount of protein, preferably on a picogram to microgram scale. Each screening sample has picogram to microgram amounts of protein in a picoliter to nanoliter volume. Predetermined protein crystal growth conditions are maintained and crystal growth is analyzed using both qualitative and quantitative criteria.

A microarray is provided for use in methods of screening protein crystal growth. Preferably the microarray has a plurality of micro-chambers in the microarray. The micro-chambers may be passive or a combination of passive micro-chambers that are connected with miniaturized active control elements such as, but not limited to, valves, pumps and electrodes. A protein solution is automatically dispensed into the micro-chambers. The protein crystal growth conditions of each of the micro-chambers is adjusted so that the protein crystal growth conditions of at least two of the micro-chambers differs. Protein crystal growth in the micro-chambers is then analyzed based on both the qualitative amount of crystallization and the quality of the crystals formed.

Additional objects, advantages, and features of the present invention will become apparent from the following description and appended claims, taken in conjunction with the accompanying drawings.

### Brief Description Of The Drawings

The various advantages of the present invention will become apparent to one skilled in the art by reading the following specification and subjoined claims and by referencing the following drawings in which:
Figure 1 is a schematic illustrating a two well design in a microarray;
Figure 2A is a schematic showing a top view of the placement of protein and precipitate solutions in a one well design;
Figure 2B is a schematic showing a side view of placement of protein and precipitate solutions in a one well design;
Figure 2C is a schematic showing a side view of an alternative placement of protein and precipitate solutions in one well;
Figure 2D is a schematic showing a side view of placement of protein and precipitate solutions in two wells;
Figure 2E is a schematic showing a top view of the placement of protein and precipitate solutions in a two well design;
Figure 3 is a photograph showing a microarray; and
Figure 4 is a photograph of a protein crystal obtained with nanogram amounts of protein in nanoliter volumes.

### Detailed Description of Invention

The method of the present invention is for screening protein crystal growth conditions in protein solutions employing a minimal amount of protein in a minimal volume, preferably on a pico, nano or meso scale. Pico, nano or meso scale as used herein preferably employs (on average) picogram (pg), nanogram (ng) or microgram (µg) amounts of protein in picoliter (pl) or nanoliter (nl) volumes. Preferably, the amount of protein in each screening sample is less than about 5 µg. More preferably, the amount of protein in a screening sample will be less than about 1 µg. The volume of protein solution in a screening sample is from about 0.001 nl to about 250 nl and preferably about 0.01 nl to about 10 nl. It will be appreciated by those skilled in the art that the volumes actually employed for any particular protein will be a function of (without limitation) the target protein and its concentration in the protein solution.

The protein solution contains one or more desired proteins for crystallization. As used herein, the term "protein" is meant to include all naturally occurring and synthetic peptides, polypeptides, proteins, and protein complexes. In one preferred embodiment the concentration of protein in the solution is from about 0.1 µg/µl to about 50 µg/µl, more preferably from about 0.1 µg/µl to about 10 µg/µl, and still more preferably about 0.1 µg/µl to about 1.0 µg/µl. In another preferred embodiment, the solution is buffered to a pH between about 2.0 and about 10.0, more preferably from about 3.0 to about 8.5. If desired, the protein solution may optionally contain agents that aid in solubilizing the protein at the desired protein concentration or conditions. For example, if the protein is a membrane protein, the protein solution may optionally contain one or more surface active agents, such as a detergent mixture. In one preferred embodiment, the protein solution also comprises components that assist in crystallization. By way of non-limiting example, the protein solution will comprise an aqueous salt solution, polyethylene glycol, or an alcohol. Such components as well as their selection, ranges, contraindications and the like are well known to those skilled in the art. See, for example, Gilliland, G.L. et al., *Acta Crystallogr.* D50:408-413 (1994); McPherson, A., *Crystallization of Biological Molecules,* Cold Spring Harbor Press, Cold Spring Harbor, NY, pp. 487-524 (1999).

The protein solution is dispensed onto a platform. The platform is a microarray. The solution is preferably dispensed using a device with picoliter or nanoliter accuracy. Preferably the dispensing device has at least a 90% accuracy on a picoliter or nanoliter scale. The protein solution can be dispensed manually using, for example, a syringe. In a highly preferred embodiment, automatic dispensing devices are used to dispense the protein solution.

A second solution, the reservoir or precipitate solution is provided. The precipitate solution is a solution that helps to bring about protein crystallization. It can comprise, for example, a salt solution, an alcohol or a polyethylene glycol. The second solution is provided either before, after, or simultaneously with the protein solution. The volume of the precipitate solution is typically equal to or greater than the volume of protein solution. The placement of the second solution is in fluid communication with the first solution. Fluid communication is liquid-liquid communication. Generally, a channel is provided for fluid communication. A channel is broadly defined herein as a space that enables fluid communication to occur.

The protein solution and precipitate solution contact each other at an interface.

Or, in an alternate embodiment, a single source or reservoir of the second solution may be employed. In yet another alternate embodiment, a desiccant source or a dry gaseous reservoir may be employed in place of the second solution. Specific conditions and variations in these methods are well known to the skilled artisan.

Protein crystal growth is monitored periodically, either qualitatively, quantitatively, or both. This may be by manual inspection using high resolution microscopy or electron microscopy. Preferably, protein crystal growth may be monitored automatically, by, for example, high resolution optical means which automatically detects crystal growth based on, for example, edge analysis. If desirable crystal growth is observed in a sample, the protein crystal growth conditions of that sample can be reproduced on a macro scale to produce a protein crystal for further analysis. Alternatively, if a precipitate or a clear sample is observed, these conditions can be used to optimize the conditions for additional screening. It will be appreciated that the platform must employ at least one path that is visually and/or optically clear to the method of detection.

The method of the present invention for screening protein crystal growth employs a microarray with a plurality of wells or reservoirs as the platform. A microarray may be constructed, for example, similar to a micro-electromechanical chip. The microarray preferably has a planar shape and employs a size and thickness that are compatible with manual or automated plate grippers. The microarray can be made from different materials and by different techniques known to those skilled in the art. The material of the microarray that includes the wells or reservoirs is preferably minimally water absorbing, and is otherwise sufficiently unreactive with the components of the solution. This may be done as a laminate or provided as a coating, for example. Alternatively, a material that absorbs water at a predictable rate can also be used to construct the wells or reservoirs. The volumes of protein and precipitate solutions may then be adjusted to compensate for the water absorption of the material. Preferred materials include, but are not limited to, glass, fused silicon, quartz, a silicon wafer, a polymer or a polysulphone. Alternatively, the microarray can be made from a material coated with a hydrophobic material, such as polysulphone, to limit water absorption in the microarray. Alternatively, the microarray comprises more than one material. Preferably, the microarray is a composite with a bottom of thin glass plate bonded to plastic, glass, silicon rubber or other materials in which wells can be manufactured, with at least one side providing an optical path that is acceptable to the detection technique employed.

In an alternate embodiment, the surfaces of the wells are hydrophobic. For example, the material of the microarray may have a hydrophobic surface. Alternatively, the surfaces of the wells may be coated with a hydrophobic coating. Although not necessary, the hydrophobic surfaces of the wells prevent the drops of solutions from spreading.

The microarray includes a multitude of micron sized wells on the surface of the chip. The term wells encompasses wells, micro-chambers and any indentation sufficient of holding or retaining a desired volume of from about 0.001 nl to about 500 nl, preferably from about 0.01 nl to about 20 nl. The wells are spaced from each other on the surface. The precise number of wells on the surface of the microarray can vary, and the total number of wells on the surface is a matter of choice for the user.

Each of the wells has a volume sufficient to hold an amount of protein solution adequate for growing a protein crystal Each of the wells holds a volume from about 0.001 nl to about 250 nl, preferably from about 0.01 nl to about 10 nl.

The wells of the microarray are made by using an etchant such as hydrogen fluoride or by other known etching or fabrication techniques.

The wells can include known means for controlling conditions, individually or collectively, such as pressure, heating or cooling the wells, humidity levels in the wells as well as known means for stirring materials loaded into the wells.

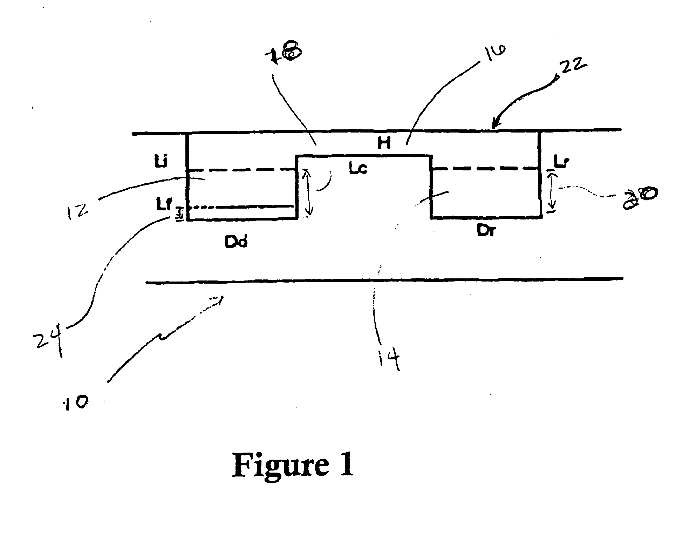

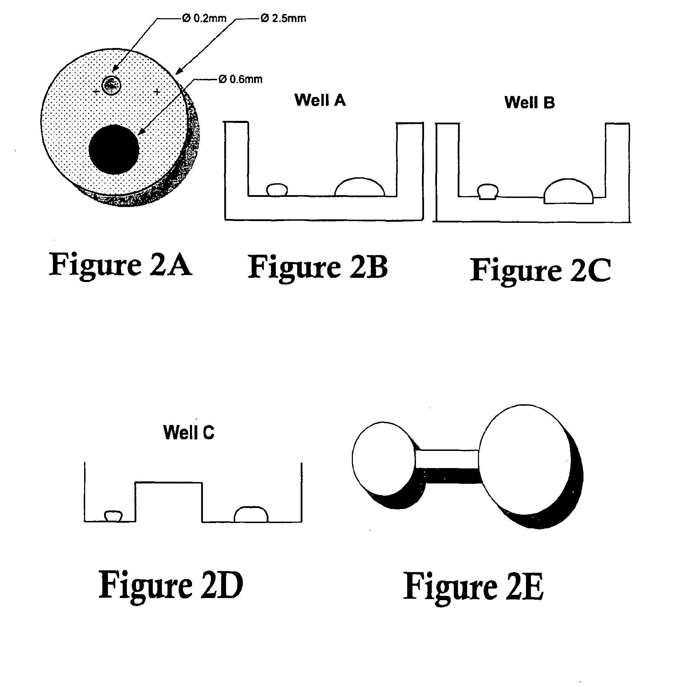

In one arrangement, the wells of the microarray are not connected and separate from each other. In an alternative arrangement, adjacent wells of the microarray are connected by one or more channels which provide fluid communication between the adjacent wells (Figures 1 and 2D-E). Preferably, the connecting channels will have cross-section dimensions and length allowing control over the rate of transport of fluid, vapor, buffer, or precipitating or crystallizing agents through the channels. In one embodiment, varying the dimensions of the channels controls protein crystal growth condition. In an alternate embodiment, protein crystal growth conditions are controlled by placing a material in the micro-channels that controls fluid communication between the wells. Non-limiting examples are membranes, acrylamide or agarose. For example, the connecting micro-channels are from about 0.0001 to about 0.2 microns wide and from about 0.00005 to about 0.1 microns deep. Alternatively, the micro-channels are from about 0.0001 to about 2.0 microns wide and from about 0.00005 to about 0.5 microns deep. The micro-channels are formed in the microarray chip by the known etching techniques.

An example of two wells in a microarray (10) connected by a micro-channel is shown in Figure 1. The protein solution well 12 is connected to precipitate solution well 14 by a microchannel 16. The dimensions of each well are designed to hold the desired amount of solution and may have the same or different dimensions. Initially, protein sample is dispensed into well 12 to an initial liquid height 18 and precipitate solution is dispensed into well 14 with liquid height 20. The top of the wells and microchannel are sealed by an optically clear cover 22.

The concentration of the protein solution in well 12 precipitates protein crystal formation.

The microarray can also include a known means for transmitting a fluid or gas to the wells of the microarray from an external source. For example, an external mechanical pumping system marketed by Watson-Marlowe, Inc., under the trade designation "205U" can be used. The pumping system is a multi-channel cassette which delivers fluid or gas in reproducible and accurately controlled amounts.

Optionally, micro-valves are disposed in the wells and micro-channels to regulate the flow of fluid or vapor between the wells and through the micro-channels in a known manner.

An automated dispensing mechanism capable of accurately and/or repeatedly dispensing picoliter and/or nanoliter volumes is also provided. Preferably, the automated dispensing mechanism has an accuracy of at least about 90%. The automated dispensing mechanisms are preferably Piezo-based or fast solenoid dispensing mechanisms. More preferable, the dispensing mechanism is a fast solenoid dispensing mechanism. The dispenser has a large number of parallel capillaries. The capillaries are in fluid communication with a source of protein solution, a source of precipitate solution, and a source of buffer solution. The dispensing can be actuated by ultrasonic transducers that efficiently produce a pressure wave in the capillaries that contain the solutions. The dispenser is analogous to ink jet printer heads for computer printers but the fluid is not heated, thus not damaging the solutions.

The protein solution preferably comprises an aqueous protein solution at a concentration of from about 0.1 µg/µl to about 50 µg/µl. Preferably, the concentration is from about 0.1 µg/µl to about 10 µg/µl, more preferably from about 0.1 µg/µl to about 1.0 µg/µl. Preferably, the protein solution comprises a detergent mixture when crystallizing membrane proteins. The precipitate solution preferably comprises a concentrated aqueous salt solution or polyethylene glycol as precipitating agents. The buffer solution preferably has pH between about 2 and about 10.

The automated dispensing mechanism dispenses an initial volume of protein solution, an initial volume of precipitate solution, and an initial volume of buffer solution from the source of protein solution, the source of precipitate solution, and the source of buffer solution, respectively, into preselected wells or connecting channels of the microarray.

The placement of the initial volume of protein solution, the initial volume of precipitate solution, and the initial volume of buffer solution in the preselected wells or channels of the microarray is dependent upon the method utilized to effect crystallization of the protein in the protein solution.

In the liquid-liquid diffusion method, the initial volume of protein solution is placed in one set of preselected wells, and the initial volume of precipitate solution is placed in a separate or different set of wells. The protein solution wells are connected to the precipitate solution wells by micro-channels. The initial volume of buffer solution may be placed in the micro-channels, or alternatively added directly to the initial volume of protein solution and/or precipitate solution.

The concentration, amounts, precipitate type, and pH of the initial volumes of protein solution, precipitate solution, and buffer solution are primary conditions which determine protein crystal growth in a protein solution. In preparing the initial solutions, and in the automated dispensing mechanism placement, these conditions and the sample placement are varied in accordance with a pre-designed program.

A cover plate is affixed to the microarray to convert the wells to micro-chambers and to convert the micro-channels to a capillary tube structure. The cover plate can made of the same or different material as the microarray, but the cover plate (or some portion of the well or chamber) must be transparent to permit optical analysis of the protein solutions in the chambers of the microarray. Preferably, the cover plate will be glass or other material that is visually or optically clear, such as an optically clear tape.

Alternatively, the environment surrounding the microarray can be controlled to limit evaporation of the solutions. Under controlled conditions of, for example, temperature and humidity, covering the samples may not be necessary.

The crystallizing agent in the precipitate solution, in selected micro-chambers, diffuses via the connecting capillaries to selected micro-chambers containing protein solution.

Protein crystal growth in the different chambers are then monitored by high resolution or other optical means which automatically detects crystal growth based on well known edge analysis. Alternatively, the protein crystal growth can be monitored by manual inspection using high resolution microscopy or electron microscopy. Preferably the protein crystal growth in the chambers is monitored by high resolution optical means which automatically detects crystal growth based on edge analysis.

Once crystal growth in a chamber is detected, that chamber's protein crystal growth conditions can be reproduced on a macro scale to produce a protein crystal which can be analyzed by x-ray crystallography. Alternatively, if a precipitate or clear sample is observed, the conditions in those samples can be used to optimize conditions for additional screening.

If desired, fluid or gas can delivered to the micro-chambers in reproducible and accurately controlled amounts from an external source by the external mechanical pumping system described above. Gas can also be delivered from the pressure generated by a standard glass bottle or tank. The fluid or gas delivered to the micro-chambers can be regulated by the micro-valves. The fluid or gas can be used to further alter the crystal growth conditions of the micro-chamber and increase the size of the protein crystals grown. These protein crystals can then be harvested and examined by x-ray crystallography or nuclear magnetic spectroscopy or other appropriate techniques.

Advantages of the present invention should now be apparent. The present invention provides a method of screening protein crystal growth conditions on a nano or meso scale. The method provides a means of screening protein crystal growth conditions for proteins that cannot be expressed in milligram quantities as well as those that can be expressed in larger quantities. Moreover, the substantial reduction in protein needed for the present invention reduces the costs associated with screening protein crystal growth conditions.

Also provided is an apparatus for screening crystal growth conditions. The apparatus comprises a microarray for the protein and precipitate solutions, an automatic dispensing mechanism for dispensing the solutions and an automated means for analyzing crystal growth.

The desired solutions, i.e., protein, precipitate and a buffer, are preferably automatically dispensed at a preset picoliter or nanoliter volume into the microarray by an automated dispensing mechanism. Preferably, the automatic dispensing mechanism dispenses discrete drops. Screening conditions such as the type of buffer and pH can be varied from sample to sample by programming the automatic dispenser. For example, arbitrary screens varying pH could be programmed by mixing the proper ratios using different drop counts from different stock solutions having different pH values. A pH range from 2.0 to 10.0 is then screened in steps of 0.2-0.5 pH units. Other conditions, such as crystallization agents and salt concentration are also controlled in a similar manner.

Mixing of the reagents can either be done before dispensing or after the solutions are dispensed into the microarray. Mixing in the microarray, for example, can be accomplished by ultrasonic mixing, high-speed dispensing of picoliter drops, rapid temperature fluctuation, or by static diffusion.

After mixing, preferably the wells of the microarray are sealed to control the microenvironment in the wells and to prevent evaporation of the solutions to dryness. More preferably, the wells are sealed with optically clear tape. Sealing the microarray involves an arm mounted on a YZ transverse mechanism. The X direction is along the plate transport direction. The arm, holding a roll of clear tape, moves past the last well in the row, drops to form positive vertical (Z axis) pressure, and then begins to move back in the negative Y direction while at the same time rotating the tape roll. Once the tape leaves the plate area, a guillotine mechanism shears the tape. The plate then moves in the X direction onto the next indexed row and the dispense process initializes again. Automated taping is reliably performed in many industries.

Protein crystal growth in the different wells is monitored by high resolution optical means which automatically detects crystal growth based on well known edge analysis. Such image acquisitions systems are commercially available.

The foregoing and other aspects of the invention may be better understood in connection with the following example, which is presented for purpose of illustration and not by way of limitation.

### EXAMPLE 1

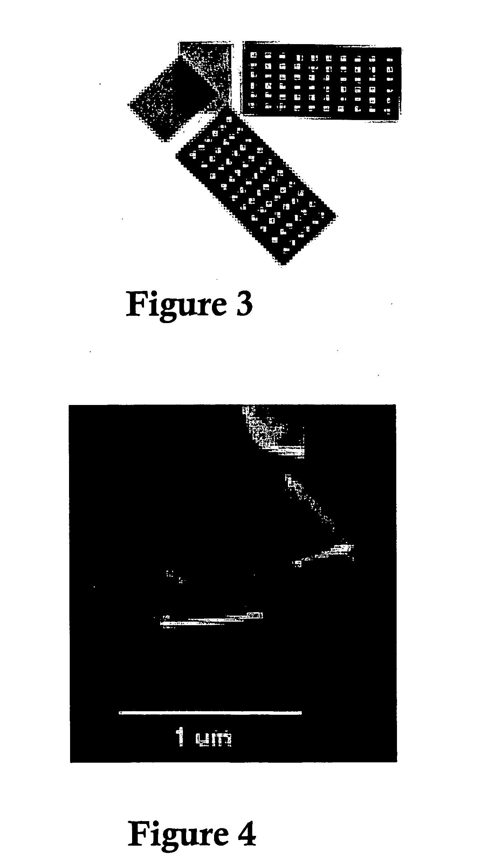

Nanoliter protein droplets were used for vapor diffusion, batch and liquid diffusion crystallization screening. The protein solutions of either lysozyme, thaumatin, or NAD synthetase were applied using a five microliter Hamilton syringe. To ensure complete wetting of the small droplet to the experiment chamber, the tip of the Hamilton syringe was placed in contact with the wall of each experiment chamber. A variety of microarrays were designed to accommodate protein solution droplets with volume ranges of 5-20 nanoliters and precipitate volumes of 100-200 nanoliters. The array prototyping was accomplished using MicroScope slides with permanent sealing of neoprene gaskets of varying thickness (0.1 mm 0.5 mm). Once all solutions were applied to an individual experiment chamber within the microscope slide, the experiment was sealed (with oil or grease) by placing a glass cover slide over the top of the gasket. Figure 3 is a photograph of a typical design for a 60 chamber array prototype (gasket thickness = 0.1 mm) and Figure 4 is a photograph of crystals that were grown to 10 nanoliter protein droplets using a similar microarray slide.

A Cartesian robotic dispensing system was used to prepare crystallization solutions in a 6 by 10 experiment array. Five nanoliters of protein plus five nanoliters of precipitant were dispensed into one merged droplet in one depression in the experiment chamber (Figure 3) and 50 nanoliters of precipitant plus 50 nanoliters of buffer were merged into one droplet in the connected depression. Thus, four solutions were dispensed for each experiment, and 6X10X4 = 240 total for the entire 6 by 10 array. Cartesian's instrument was able to dispense all of the solutions in less than 20 minutes. All external conditions used were known crystallization conditions for the particular proteins tested. The experiment was manually sealed and incubated at 22°C. for a period of one day. Crystals were observed in seventy percent of the droplets. While not wishing to be bound by theory, it is believed that the failure to observe crystals in 30% of the wells was due to inaccurate dispensing of the protein and precipitant five nanoliter drops in that the peizo tip did not position the drops together.

## Claims

1. A method of screening protein crystal growth conditions in a plurality of screening samples, employing picogram, nanogram or microgram amounts of protein, each of said screening samples having a volume of from 0.001 nl to 250 nl of a protein solution, said method comprising the steps of:
dispensing said screening samples into a plurality of wells or micro-chambers of a microarray;
controlling the protein crystal growth conditions of each of said wells or micro-chambers by adding a precipitate solution to the microarray in fluid communication with said protein solution, so that the protein crystal growth conditions in at least two of said wells or micro-chambers differ; and
monitoring protein crystallization or protein precipitation in said wells or micro-chambers:
wherein said fluid communication is by liquid-liquid diffusion of said precipitate solution and said protein solution.

2. The method of claim 1 wherein said protein solution comprises a component selected from the group consisting of buffers, surface active agents, salts, alcohols, polyethylene glycol and mixtures thereof.

3. The method of claim 1 wherein said protein solution is buffered.

4. The method of claim 1 wherein said precipitate solution and said protein solution are in different wells or micro-chambers in said microarray and said microarray has channels for fluid communication between a well or micro-chamber comprising protein solution and a well or micro-chamber comprising a precipitate solution.

5. The method of claim 4 wherein controlling protein crystal growth further comprises employing varying dimensions of the channels.

6. The method of claim 4 wherein said precipitate solution and said protein solution are in fluid communication via micro-channels.

7. The method of claim 1 wherein the precipitate solution has a volume from about 0.001 nl to about 250 nl.

8. The method of claim 1 wherein protein crystallization or protein precipitation is monitored by microscopy.

9. The method of claim 8 wherein the microscopy is differential interference contrast microscopy.

10. The method of claim 1 wherein the protein solution is dispensed into said wells or micro-chambers by fast solenoid dispensing.

11. The method of claim 1 wherein the microarray has a plurality of wells into which the protein solution is dispensed.

12. The method of claim 1 wherein the microarray has a plurality of micro-chambers into which the protein solution is dispensed.

13. The method of claim 11 wherein a cover plate is affixed to the microarray to convert the wells to micro-chambers, optionally wherein the cover plate is made of glass or optically clear tape.

14. The method of any of claims 1 to 12 wherein the environment surrounding the microarray is controlled to limit evaporation of the solutions.

15. A microarray (10) for screening protein crystal growth at nanogram or picogram protein amounts comprising a plurality of wells or micro-chambers wherein said wells or micro-chambers are each adapted for holding volumes of protein solution (12) from about 0.001 nl to about 250 nl, the microarray further comprising a plurality of wells or micro-chambers fort holding a precipitate solution (14) and wherein said microarray has channels (16) for fluid communication by liquid-liquid diffusion between wells or micro-chambers holding protein solution and wells or micro-chambers holding precipitate solution.

16. The microarray of claim 15 wherein said wells or micro-chambers comprise a material that is minimally water absorbing.

17. The microarray of claim 15 further comprising an optically clear path from said wells or micro-chambers.

18. The microarray of claim 15 wherein said wells or micro-chambers comprise a material that is substantially hydrophobic.

19. The microarray of claim 15 wherein at least two channels have different dimensions.

20. The microarray of claim 15 wherein said wells or micro-chambers in said microarray can be sealed to prevent evaporation from said wells or micro-chambers.

## Patentansprüche

1. Verfahren zum Durchmustern von Proteinkristallwachstumsbedingungen in einer Vielzahl von Screeningproben, verwendend Pikogramm-, Nanogramm- oder Mikrogrammmengen von Protein, wobei jede dieser Screeningproben ein Volumen von 0,001 nl bis 250 nl einer Proteinlösung aufweist, das Verfahren umfassend die Schritte von:
Dispensieren dieser Screeningproben in eine Vielzahl von Wells oder Mikrokammern eines Mikroarrays;
Kontrollieren der Proteinkristallwachstumsbedingungen von jedem dieser Wells oder Mikrokammern durch Zugabe einer Präzipitatlösung zu dem Mikroarray, der sich in Fluidkommunikation mit dieser Proteinlösung befindet, so dass die Proteinkristallwachstumsbedingungen in mindestens zwei dieser Wells oder Mikrokammern differieren; und
Überwachen der Proteinkristallisation oder Proteinpräzipitation in diesen Wells oder Mikrokammern:
wobei diese Fluidkommunikation durch Flüssigkeits-Flüssigkeits-Diffusion dieser Präzipitatlösung und dieser Proteinlösung erfolgt.

2. Verfahren nach Anspruch 1, wobei diese Proteinlösung eine Komponente ausgewählt aus der Gruppe bestehend aus Puffern, oberflächenaktiven Agenzien, Salzen, Alkoholen, Polyethylenglycol und Mischungen davon umfasst.

3. Verfahren nach Anspruch 1, wobei diese Proteinlösung gepuffert ist.

4. Verfahren nach Anspruch 1, wobei diese Präzipitatlösung und diese Proteinlösung sich in verschiedenen Wells oder Mikrokammern in diesem Mikroarray befinden und dieser Mikroarray Kanäle für die Fluidkommunikation zwischen einem eine Proteinlösung umfassenden Well oder Mikrokammer und einem eine Präzipitatlösung umfassenden Well oder Mikrokammer aufweist.

5. Verfahren nach Anspruch 4, wobei das Kontrollieren des Proteinkristallwachstums weiterhin die Verwendung variierender Dimensionen der Kanäle umfasst.

6. Verfahren nach Anspruch 4, wobei sich diese Präzipitatlösung und diese Proteinlösung in Fluidkommunikation via Mikrokanälen befinden.

7. Verfahren nach Anspruch 1, wobei die Präzipitatlösung ein Volumen von etwa 0,001 nl bis 250 nl aufweist.

8. Verfahren nach Anspruch 1, wobei Proteinkristallisation und Proteinpräzipitation durch Mikroskopie überwacht wird.

9. Verfahren nach Anspruch 8, wobei die Mikroskopie differentielle Interferenzkontrastmikroskopie ist.

10. Verfahren nach Anspruch 1, wobei die Proteinlösung in diese Wells oder Mikrokammern durch schnelles Solenoid-Dispensieren dispensiert wird.

11. Verfahren nach Anspruch 1, wobei der Mikroarray eine Vielzahl von Wells aufweist, in welche die Proteinlösung dispensiert wird.

12. Verfahren nach Anspruch 1, wobei der Mikroarray eine Vielzahl von Mikrokammern aufweist, in welche die Proteinlösung dispensiert wird.

13. Verfahren nach Anspruch 11, wobei eine Deckplatte auf dem Mikroarray angebracht ist, um die Wells oder Mikrokammern zu konvertieren, und wobei die Deckplatte gegebenenfalls aus Glas oder optisch-durchsichtigem Isolierband ist.

14. Verfahren nach einem der Ansprüche 1 bis 12, wobei die Umgebung, die den Mikroarray umgibt, kontrolliert wird, um Verdunstung der Lösungen einzuschränken.

15. Mikroarray (10) zum Durchmustern von Proteinkristallwachstum in Nanogramm- oder Pikogrammproteinmengen, umfassend eine Vielzahl von Wells oder Mikrokammern, wobei jedes dieser Wells oder Mikrokammern zum Halten von Volumen an Proteinlösung (12) von etwa 0,001 nl bis etwa 250 nl angepasst ist, der Mikroarray weiterhin umfassend eine Vielzahl von Wells oder Mikrokammern zum Halten einer Präzipitatlösung (14) und wobei dieser Mikroarray Kanäle (16) für die Fluidkommunikation durch Flüssigkeits-Flüssigkeits-Diffusion zwischen Proteinlösung haltenden Wells oder Mikrokammern und Präzipitatlösung haltenden Wells oder Mikrokammern aufweist.

16. Mikroarray nach Anspruch 15, wobei diese Wells oder Mikrokammern ein Material umfassen, das geringfügig wasseradsorbierend ist.

17. Mikroarray nach Anspruch 15, weiterhin umfassend einen optisch durchsichtigen Pfad von diesen Wells oder Mikrokammern.

18. Mikroarray nach Anspruch 15, wobei diese Wells oder Mikrokammern ein Material umfassen, das im Wesentlichen hydrophob ist.

19. Mikroarray nach Anspruch 15, wobei mindestens zwei Kanäle unterschiedliche Dimensionen aufweisen.

20. Mikroarray nach Anspruch 15, wobei diese Wells oder Mikrokammern in diesem Mikroarray versiegelt werden können, um Verdunstung aus diesen Wells oder Mikrokammern zu verhindern.

## Revendications

1. Procédé de criblage des conditions de croissance d'un cristal de protéine dans une pluralité d'échantillons de criblage, utilisant des quantités de protéine de l'ordre du picogramme, nanogramme ou microgramme, chacun desdits échantillons de criblage ayant un volume de 0,001 nl à 250 nl d'une solution de protéine, ledit procédé comprenant les étapes consistant à :
distribuer lesdits échantillons de criblage dans une pluralité de puits ou de micro-cuves d'un microréseau ;
contrôler les conditions de croissance d'un cristal de protéine de chacun desdits puits ou micro-cuves en ajoutant une solution de précipitation au microréseau en communication de fluide avec ladite solution de protéine, de sorte que les conditions de croissance d'un cristal de protéine dans au moins deux desdits puits ou micro-cuves diffèrent ; et
suivre la cristallisation de la protéine ou la précipitation de la protéine dans lesdits puits ou micro-cuves ;
dans lequel ladite communication de fluide se fait par diffusion liquide-liquide de ladite solution de précipitation et de ladite solution de protéine.

2. Procédé selon la revendication 1 dans lequel ladite solution de protéine comprend un composant choisi dans le groupe constitué de tampons, agents surfactants, sels, alcools, polyéthylène glycol et des mélanges de ceux-ci.

3. Procédé selon la revendication 1 dans lequel ladite solution de protéine est tamponnée.

4. Procédé selon la revendication 1 dans lequel ladite solution de précipitation et ladite solution de protéine sont dans différents puits ou micro-cuves dans ledit microréseau et ledit microréseau a des canaux pour une communication de fluide entre un puits ou une micro-cuve comprenant la solution de protéine et un puits ou une micro-cuve comprenant une solution de précipitation.

5. Procédé selon la revendication 4 dans lequel le contrôle de la croissance du cristal de protéine comprend en outre l'utilisation des dimensions variables des canaux.

6. Procédé selon la revendication 4 dans lequel ladite solution de précipitation et ladite solution de protéine sont en communication de fluide par l'intermédiaire de micro-canaux.

7. Procédé selon la revendication 1 dans lequel la solution de précipitation a un volume d'environ 0,001 nl à environ 250 nl.

8. Procédé selon la revendication 1 dans lequel la cristallisation de la protéine ou la précipitation de la protéine est suivie par microscopie.

9. Procédé selon la revendication 8 dans lequel la microscopie est la microscopie à contraste interférentiel différentiel.

10. Procédé selon la revendication 1 dans lequel la solution de protéine est distribuée dans lesdits puits ou micro-cuves par une distribution rapide en solénoïde.

11. Procédé selon la revendication 1 dans lequel le microréseau a une pluralité de puits dans lesquels la solution de protéine est distribuée.

12. Procédé selon la revendication 1 dans lequel le microréseau a une pluralité de micro-cuves dans lesquelles la solution de protéine est distribuée.

13. Procédé selon la revendication 11 dans lequel une plaque de recouvrement est apposée au microréseau afin de transformer les puits en micro-cuves, facultativement
dans lequel la plaque de recouvrement est faite de verre ou d'un film optiquement clair.

14. Procédé selon l'une quelconque des revendications 1 à 12 dans lequel l'environnement entourant le microréseau est contrôlé afin de limiter l'évaporation des solutions.

15. Microréseau (10) destiné à cribler la croissance d'un cristal de protéine à des quantités de protéine de l'ordre du nanogramme ou picogramme comprenant une pluralité de puits ou de micro-cuves dans lequel lesdits puits ou micro-cuves sont chacun adaptés pour contenir des volumes de solution de protéine (12) d'environ 0,001 nl à environ 250 nl, le microréseau comprenant en outre une pluralité de puits ou de micro-cuves destinés à contenir une solution de précipitation (14) et dans lequel ledit microréseau a des canaux (16) pour une communication de fluide par diffusion liquide-liquide entre les puits ou les micro-cuves contenant la solution de protéine et les puits ou les micro-cuves contenant la solution de précipitation.

16. Microréseau selon la revendication 15 dans lequel lesdits puits ou micro-cuves comprennent un matériau qui absorbe un minimum d'eau.

17. Microréseau selon la revendication 15 comprenant en outre un chemin optiquement clair à partir desdits puits ou micro-cuves.

18. Microréseau selon la revendication 15 dans lequel lesdits puits ou micro-cuves comprennent un matériau qui est en grande partie hydrophobe.

19. Microréseau selon la revendication 15 dans lequel au moins deux canaux ont des dimensions différentes.

20. Microréseau selon la revendication 15 dans lequel lesdits puits ou micro-cuves dans ledit microréseau peuvent être scellés afin de prévenir l'évaporation desdits puits ou micro-cuves.
